(19) Europäisches Patentamt
European Patent Office
Office européen des brevets

(11) Veröffentlichungsnummer: **0 098 982**
**B1**

# (12) EUROPÄISCHE PATENTSCHRIFT

(45) Veröffentlichungstag der Patentschrift: **06.08.86**

(51) Int. Cl.⁴: **G 03 C 1/68**

(21) Anmeldenummer: **83105775.7**

(22) Anmeldetag: **13.06.83**

(54) **Photopolymerisierbares Gemisch und damit hergestelltes photopolymerisierbares Kopiermaterial.**

(30) Priorität: **21.06.82 DE 3223104**

(43) Veröffentlichungstag der Anmeldung: **25.01.84 Patentblatt 84/4**

(45) Bekanntmachung des Hinweises auf die Patenterteilung: **06.08.86 Patentblatt 86/32**

(84) Benannte Vertragsstaaten: **DE FR GB**

(56) Entgegenhaltungen:
**DE - A - 2 016 791**
**DE - A - 2 133 460**
**DE - A - 3 028 136**
**FR - A - 2 316 254**
**FR - A - 2 383 202**
**US - A - 4 180 403**
**US - A - 4 308 338**

**Die Akte enthält technische Angaben, die nach dem Eingang der Anmeldung eingereicht wurden und die nicht in dieser Patentschrift enthalten sind.**

(73) Patentinhaber: **HOECHST AKTIENGESELLSCHAFT, Postfach 80 03 20, D-6230 Frankfurt am Main 80 (DE)**

(72) Erfinder: **Dönges, Reinhard, Dr., Oranienstrasse 1, D-6232 Bad Soden (DE)**
Erfinder: **Horn, Klaus, Dr., Lessingstrasse 53, D-6238 Hofheim/Ts. (DE)**

**EP 0 098 982 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein photopolymerisierbares Gemisch, das als wesentliche Bestandteile (a) eine radikalisch polymerisierbare Verbindung mit endständigen ethylenisch ungesättigten Gruppen, (b) ein polymeres Bindemittel und (c) einen durch Strahlung aktivierbaren Polymerisationsinitiator enthält.

Derartige photopolymerisierbare Gemische sind z.B. aus den US-A 2 760 863, 3 060 023 und 3 149 975 bekannt. Als polymerisierbare ethylenisch ungesättigte Verbindungen werden dort niedermolekulare und hochmolekulare Verbindungen mit endständigen bzw. seitenständigen Vinyl- oder Vinylidengruppen, insbesondere Acryl- und Methacrylsäureester von niedermolekularen oder hochmolekularen Polyhydroxyverbindungen, beschrieben. In der Praxis haben sich bisher fast ausschliesslich photopolymerisierbare Materialien auf der Basis solcher Ester als polymerisierbare Verbindungen durchgesetzt. Von diesen sind es insbesondere die niedermolekularen Vertreter, die in der Technik bevorzugt eingesetzt werden.

Bei der Verarbeitung von photopolymerisierbaren Materialien der angegebenen Gattung ist es notwendig, den Einfluss des Luftsauerstoffs auf die radikalische Polymerisation auszuschalten oder so weit wie möglich zu unterdrücken. Das erfolgt zumeist dadurch, dass man die photopolymerisierbare Schicht mit einem abziehbaren sauerstoffundurchlässigen Deckblatt (US-A 3 060 026) oder mit einer sauerstoffundurchlässigen Deckschicht abdeckt, die in dem Entwickler löslich ist (US-A 3 458 311). Hierdurch wird verhindert, dass während der lichtinduzierten Polymerisation Sauerstoff in die Schicht eindiffundiert und dort zu Kettenabbruchreaktionen führt, die sich in einer unvollständigen Polymerisation und damit geringeren Lichtempfindlichkeit auswirken.

Der Nachteil der bekannten Materialien liegt in dem zusätzlichen Arbeitsschritt, der für das Aufbringen von Deckfolie oder Deckschicht erforderlich ist. Weiterhin wird die Bildauflösung bei Verwendung selbsttragender Deckfolien, die in der Regel eine Dicke um 20 µm haben, beim Kontaktkopieren verschlechtert. Deckschichten, die im Entwickler löslich sind, haben einen rascheren Verbrauch desselben und eine zusätzliche Abwasserbelastung zur Folge. Man hat deshalb versucht, photopolymerisierbare Materialien herzustellen, die auch ohne Deckschicht eine ausreichende Lichtempfindlichkeit bei der bildmässigen Polymerisation zeigen.

In der DE-A 28 30 143 wird ein derartiges Material beschrieben, das bestimmte polymerisierbare Verbindungen mit höherem Molekulargewicht und bestimmte Initiatorsysteme enthält und daher eine geringe Sauerstoffempfindlichkeit aufweist. Als polymerisierbare Verbindungen werden Acryl- bzw. Methacrylsäureester verwendet, die durch Umsetzen von Acryl- oder Methacrylsäure mit Bis-epoxyverbindungen erhalten werden.

Ähnliche Materialien werden in der DE-A 26 02 410 beschrieben, die bevorzugt zur Herstellung von Photoresistbildern verwendet werden.

Die bekannten Materialien haben neben einer Reihe von Vorteilen den Nachteil, dass sich mit ihnen nur bestimmte erwünschte Eigenschaften einstellen lassen. So ist es z.B. erwünscht, dass photopolymerisierbare Schichten, die ohne sauerstoffhemmende Deckschicht verwendet werden sollen, nicht klebrig, jedoch flexibel sind und keine Tendenz zur Kristallisation zeigen. Es ist im allgemeinen nicht möglich, eine derartige Kombination von Eigenschaften ohne Zusatz anderer Monomerer zu erreichen, wodurch wiederum andere vorteilhafte Eigenschaften beeinträchtigt werden.

Der Erfindung liegt die Aufgabe zu Grunde, durch Strahlung polymerisierbare Gemische zu formulieren, die sich durch hohe Strahlungsempfindlichkeit auszeichnen, die nicht kristallisierbar sind und trotzdem Schichten mit nicht klebender Oberfläche herzustellen gestatten, besonders dann, wenn auf eine Sauerstoff abschirmende Deckschicht verzichtet wird.

Die Erfindung geht aus von einem Gemisch, das durch Strahlung polymerisiert werden kann und als wesentliche Bestandteile

a) eine radikalisch polymerisierbare Verbindung mit endständigen Acryl- oder Methacrylsäureestergruppen,

b) ein polymeres Bindemittel, das in wässrigalkalischer Lösung löslich oder mindestens quellbar ist, und

c) einen durch Strahlung aktivierbaren Polymerisationsinitiator enthält.

Das erfindungsgemässe Gemisch ist dadurch gekennzeichnet, dass es als polymerisierbare Verbindung (a) eine Verbindung der allgemeinen Formel I

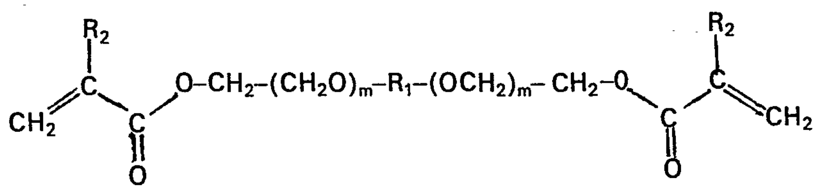

(I)

enthält, worin

$R_1$ eine Naphthylen-, Biphenyldiyl- oder Dinaphthylmethandiylgruppe oder eine aus zwei über eine Brücke verbundenen Phenylenresten gebildete Gruppe ist, wobei die Brücke ein Sauerstoff- oder Schwefelatom, eine Sulfongruppe oder eine durch Carbonsäure- oder Carbonsäurealkylestergruppen, Halogenatome oder Phenylgruppen substituierte und gegebenenfalls über einen solchen Substituenten mit der Gruppe $R_1$

eines anderen Moleküls verbundene Alkylengruppe ist,

$R_2$ ein Wasserstoffatom oder eine Methylgruppe und

m 0 oder 1 ist, wobei m = 1 ist, wenn $R_1$ eine Naphthylen- oder Biphenyldiylgruppe ist.

Beispiele für Gruppen $R_1$ sind Naphth-2,7-ylen, Naphth-1,5-ylen, Dinaphth-1-ylmethan-, 2'-ylen, Biphenyl-4,4'-diyl und 1,1,1-Triphenylethan-4,4'-ylen. Bevorzugt werden Gruppen, in denen zwei Phenylgruppen durch ein Sauerstoff- oder Schwefelatom oder durch eine substituierte Alkylengruppe, insbesondere durch ein Sauerstoffatom oder eine durch eine Carbonsäureestergruppe substituierte Alkylengruppe, verbunden sind.

Die in dem erfindungsgemässen Gemisch enthaltenen polymerisierbaren Verbindungen lassen sich nach bekannten Verfahren herstellen. So können z.B. mehrwertige Phenole $HO-R_1-OH$ durch Umsetzen mit Ethylencarbonat, Ethylenoxid, Propylenoxid oder Styroloxid (wie in Houben-Weyl, Methoden der Organischen Chemie (1965), Band VI/3, Seite 75 ff und Seite 79 ff beschrieben) in Bis-(β-hydroxy-ethoxy)-aromaten übergeführt werden, aus welchen dann polymerisierbare Verbindungen der allgemeinen Formel I mit m = 1 durch azeotrope Veresterung mit Acryl- oder Methacrylsäure erhalten werden.

Halogenmethylaromaten der Formel $Hal-CH_2-R_1-CH_2-Hal$ können mit einer ethylenisch ungesättigten Carbonsäure in Gegenwart einer Base oder mit einem Metallsalz derartiger Säuren direkt umgesetzt werden, wodurch polymerisierbare Verbindungen der allgemeinen Formel I entstehen, worin m = 0 ist.

Diese Verbindungen lassen sich auch durch Umsetzung von Hydroxymethylaromaten mit entsprechenden Carbonsäurehalogeniden oder durch Umesterung der entsprechenden Acetoxymethylverbindungen herstellen.

Die erfindungsgemässen fotopolymerisierbaren Gemische enthalten ferner polymere Bindemittel. Es können eine Vielzahl löslicher organischer Polymerisate Einsatz finden, die in wässrig-alkalischen Lösungen löslich oder mindestens quellbar sind, da sich Schichten mit solchen Bindemitteln mit den bevorzugten wässrig-alkalischen Entwicklern entwickeln lassen. Derartige Bindemittel können z.B. die folgenden Gruppen enthalten: $-COOH$, $-PO_3H_2$, $-SO_3H$, $-SO_2NH_2$, $-SO_2-NH-CO-$. Als Beispiele hierfür seien genannt: Maleinatharze, Polymerisate aus N-(p-Tolylsulfonyl) carbaminsäure- (β-methacryloyloxyethyl)-, ester und Mischpolymeriste dieser und ähnlicher Monomerer mit anderen Monomeren, ferner Methylmethacrylat-Methacrylsäure-Copolymerisate oder Mischpolymerisate aus Methacrylsäure, Alkylmethacrylaten und Methylmethacrylat und/oder Styrol, Acrylnitril u.a.

Vorzugsweise werden jedoch Styrol-Maleinsäureanhydrid- oder Styrol-Maleinsäureester-Mischpolymerisate verwendet.

Als Fotoinitiatoren können eine Vielzahl von Substanzen Verwendung finden. Beispiele sind Benzoin, Benzoinether, Mehrkernchinone, z.B. 2-Ethyl-anthrachinon, Acridinderivate, z.B. 9-Phenyl-acridin, 9-p-Methoxyphenyl-acridin, 9-Acetylamino-acridin, Benz(a)acridin; Phenazinderivate, z.B. 9,10-Dimethyl-benz(a)phenazin, 9-Methyl-benz(a)phenazin, 10-Methoxy-benz(a)phenazin, Chinoxalinderivate, z.B. 6,4',4''-Trimethoxy- 2,3-diphenyl-chinoxalin, 4',4''-Dimethoxy -2,3- diphenyl-5-aza- chinoxalin- oder Chinazolinderivate.

Die erfindungsgemässen Gemische können ausser Monomeren, Bindemitteln und Fotoinitiatoren noch eine Reihe weiterer üblicher Zusätze enthalten, z.B. Inhibitoren zur Verhinderung der thermischen Polymerisation der Monomeren, Wasserstoffdonatoren, sensitometrische Regler, Farbstoffe, Farbpigmente und ungefärbte Pigmente.

Diese Bestandteile sind zweckmässig so auszuwählen, dass sie in dem für den Initiierungsvorgang wichtigen aktinischen Strahlungsbereich möglichst nicht zu stark absorbieren.

Als aktinische Strahlung soll jede Strahlung verstanden werden, deren Energie mindestens der des kurzwelligen sichtbaren Lichts entspricht. Geeignet ist insbesondere langwellige UV-Strahlung, aber auch Elektronen-, Röntgen- und Laserstrahlung.

Die erfindungsgemässen Gemische ergeben fotopolymerisierbare Schichten mit hoher Lichtempfindlichkeit. Diese ist auch dann gegeben, wenn auf eine Sauerstoff abschirmende Deckschicht verzichtet wird. Die Schichten zeigen auch ohne Deckschicht keine Klebeneigung und sind im belichteten Zustand beständig gegen alkalische Entwickler und saure alkoholische Wischwässer.

Die Herstellung der lichtempfindlichen Materialien unter Verwendung des erfindungsgemässen Gemisches erfolgt in bekannter Weise. So kann man dieses in einem Lösungsmittel aufnehmen und die Lösung bzw. Dispersion durch Giessen, Sprühen, Tauchen oder Antragen mit Walzen auf den vorgesehenen Träger als Film aufbringen und anschliessend trocknen.

Die Kopierschichten werden in bekannter Weise belichtet und entwickelt. Als Entwickler sind wässrige, vorzugsweise wässrig-alkalische Lösungen, z.B. von Alkaliphosphaten oder Alkalisilikaten, geeignet, denen gegebenenfalls kleine Mengen an mischbaren organischen Lösungsmitteln und Netzmitteln zugesetzt werden können.

Die erfindungsgemässen Gemische eignen sich besonders in Form eines vorsensibilisierten Kopiermaterials auf einem geeigneten Träger, z.B. Aluminium oder Zink, für die fotomechanische Herstellung von Offsetdruckplatten. Sie sind ferner für die Herstellung von Trockenresistfolien, Reliefbildern, Siebdruckschablonen und Farbprüffolien geeignet, ausserdem ist eine Verwendung als Photoresistlösung möglich.

Im Folgenden wird zunächst die Herstellung der polymerisierbaren Verbindungen beschrieben.

Die daran anschliessenden Beispiele erläutern einzelne Ausführungsformen des erfindungsgemässen Gemisches. Die eingesetzten Mengen der Schichtbestandteile sind in Gewichtsteilen (Gt) angegeben. Prozentzahlen und Mengenverhältnisse sind, wenn nicht anderes angegeben ist, in Gewichtseinheiten zu verstehen.

Die Verbindungen der allgemeinen Formel I können wie folgt hergestellt werden:

A. Alkoxylierung von Phenolen der Formel $HO-R_1-OH$:

a) In eine Mischung von 22 g (0,11 mol) 4,4'-Dihydroxydiphenylether, 2 g Natriumhydroxid und 200 ml Wasser werden bei 95–100 °C in ca. 5 Stunden 22 g (0,5 mol) Ethylenoxid eingeleitet. Nach dem Abkühlen wird das Produkt abgesaugt und getrocknet. Ausbeute 27 g (0,093 mol; 85%), Schmp. 133–135 °C.

b) In eine Mischung von 150 g (0,5 mol) 2,2-Bis(4-hydroxyphenyl)-essigsäurebutylester, 10 g Natriumhydroxid und 400 ml Wasser werden bei 95–100 °C 66 g (1,5 mol) Ethylenoxid eingeleitet. Nach dem Abkühlen des Reaktionsgemisches wird das Produkt mit Essigester aus der wässrigen Phase extrahiert und das Lösungsmittel im Vakuum abdestilliert. Man erhält 140 g (0,36 mol; 72%) des öligen Produktes.

c) Eine Mischung von 75 g (0,4 mol) 4,4'-Dihydroxybiphenyl, 78 g (0,88 mol) Ethylencarbonat und 2 g pulverisiertem Kaliumhydroxid wird 2 Stunden auf 170–190 °C erhitzt. Nach dem Abkühlen wird das schwerlösliche Produkt durch Auswaschen mit Essigester von Resten der Ausgangsmaterialien befreit. Ausbeute: 84 g (0,3 mol; 75%).

B. Azeotrope Veresterung alkoxylierter Phenole

a) Eine Lösung von 1 mol 4,4'-Bis-hydroxyethoxydiphenylether und 0,5 g Hydrochinon in 500 ml Toluol wird mit 10 ml konz. Schwefelsäure versetzt und am Wasserabscheider zum Sieden erhitzt. Langsam werden 3 mol Methacrylsäure zugetropft, wobei sich ca. 40 ml einer wässrigen Phase im Wasserabscheider separieren.

Die Toluollösung wird mit 2 n Natronlauge und anschliessend mit Wasser gewaschen. Nach Einengen im Vakuum werden die letzten Lösungsmittelreste bei 60 °C und 0,1 Torr vertrieben. Es verbleiben 328 g (77%) 4,4'-Bis-(β-methacryloyloxy-ethoxy) diphenylether (Verbindung 9).

Durch Verwendung von Acryl- anstelle von Methacrylsäure werden 278 g (70%) 4,4'-Bis-(β-acryloyloxy-ethoxy) diphenylether erhalten (Verbindung 10).

b) 39 g (0,1 mol) 2,2-Bis-(4-hydroxyethoxyphenyl) essigsäurebutylester werden in 350 ml Toluol gelöst, dann werden 0,4 g Hydrochinon und 4 ml konz. Schwefelsäure zugegeben. Während in der Siedehitze 42 g (0,5 mol) Methacrylsäure langsam zugetropft werden, scheiden sich am Wasserabscheider 3,7 ml wässriger Phase ab. Nach Auswaschen mit 2 n Natronlauge und Einengen der organischen Phase verbleiben 39 g (74%) der Verbindung 13.

c) 27,5 g (36,8 mmol) Bis[2,2-bis (4-hydroxyethoxyphenyl) buttersäure] ethylenglykolester, 1,5 ml konz. Schwefelsäure und 0,15 g Hydrochinon werden in 200 ml Toluol erhitzt und 19 g (0,22 mol) Methacrylsäure werden zugetropft. Nachdem am Wasserabscheider 3,2 ml wässriger Phase abgeschieden sind, wird mit 2 n Natronlauge ausgewaschen und das Lösungsmittel abdestilliert. Es verbleiben 28 g (27,5 mmol; 75%) der Verbindung 24.

Tabelle I

Beispiele für Verbindungen der allgemeinen Formel I mit m = 1.

| Verbindung Nr. | $R_1$ | $R_2$ |
|---|---|---|
| 1 | 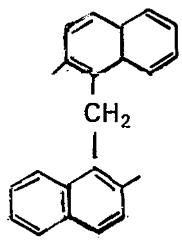 | $CH_3$ |
| 2 | 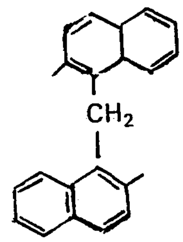 | H |
| 3 | 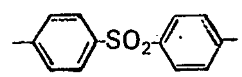 | $CH_3$ |
| 4 | 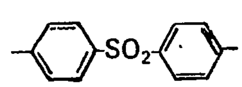 | H |
| 5 | 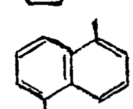 | $CH_3$ |
| 6 | 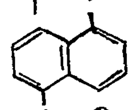 | H |
| 7 | 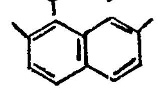 | $CH_3$ |
| 8 | 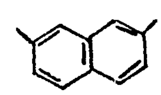 | H |
| 9 | 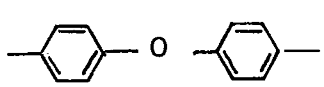 | $CH_3$ |
| 10 | 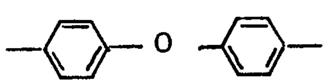 | H |

| Verbindung Nr. | $R_1$ | $R_2$ |
|---|---|---|
| 11 | 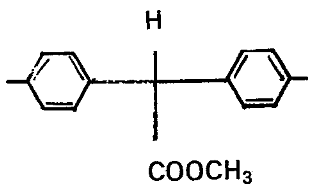 | $CH_3$ |
| 12 | 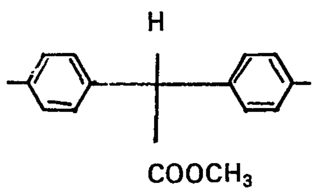 | H |
| 13 | 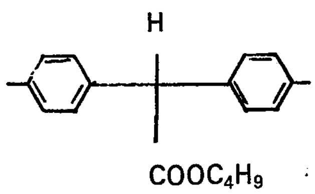 | $CH_3$ |
| 14 | 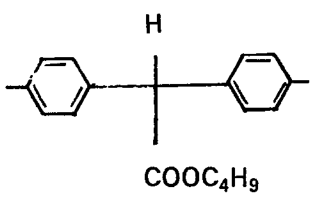 | H |
| 15 | 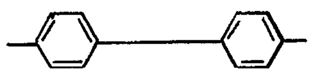 | $CH_3$ |
| 16 | 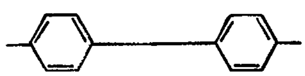 | H |
| 17 | 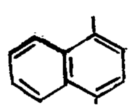 | $CH_3$ |
| 18 | 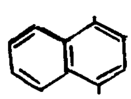 | H |
| 19 | 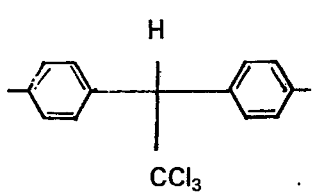 | $CH_3$ |
| 20 | 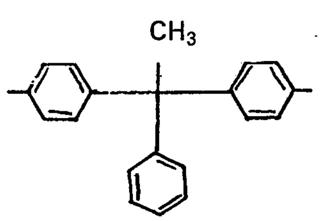 | $CH_3$ |
| 21 | 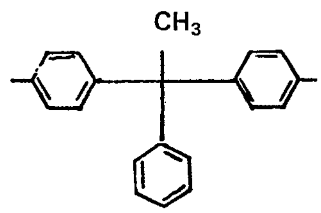 | H |
| 22 | 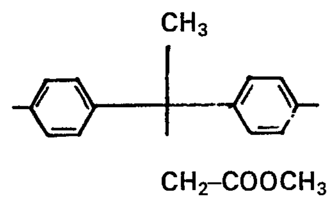 | $CH_3$ |
| 23 | 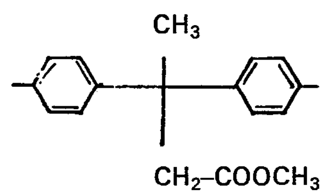 | H |
| 24 | 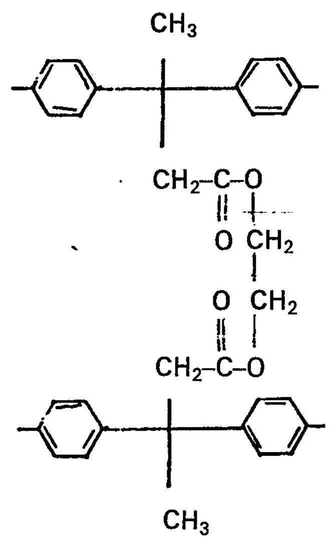 | $CH_3$ |
| 25 | 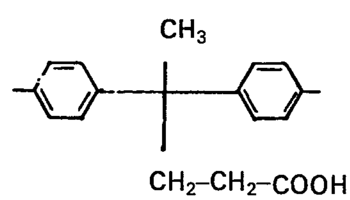 | $CH_3$ |
| 26 | 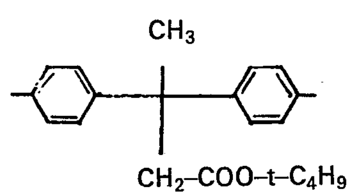 | $CH_3$ |

| Verbindung Nr. | $R_1$ | $R_2$ |
|---|---|---|
| 27 | 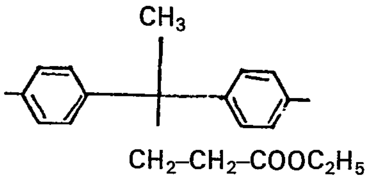 | $CH_3$ |

Beispiele für die Herstellung von Verbindungen der allgemeinen Formel I mit m = 0.

a) 78 g (0,2 mol) 4,4'-Bis-brommethyl-diphenylether, 42,5 g (0,42 mol) Triethylamin, 36 g (0,42 mol) Methacrylsäure und 0,5 g Hydrochinon werden in 300 ml Toluol 4 Stunden auf 80 °C erhitzt. Nach Absaugen vom ausgefallenen Ammoniumbromid wird mit 2 n Natronlauge, 2 n Salzsäure und mit Wasser ausgewaschen und eingeengt. Die Ausbeute an 4,4'-Bis(methacryloyloxymethyl)diphenylether (Verbindung 28) beträgt 56,6 g (0,154 mol; 77%).

b) 570 g (1,6 mol) 4,4'-Bis-brommethyl-diphenylether, 413 g (4,8 mol) Methacrylsäure und 1,6 g Hydrochinon werden in 2,5 l Methylisobutylketon gelöst und nach Zutropfen von 725 g Triethylamin 5 Stunden zum Rückfluss erhitzt. Es wird vom ausgefallenen Triethylammoniumbromid abgesaugt und mehrmals mit 2 n Natronlauge, 2 n Salzsäure und Wasser ausgerührt. Die organische Phase wird nach Zusatz von 0,4 g Hydrochinon eingeengt. Es verbleiben 350 g (0,96 mol; 60%) der Verbindung 28.

c) 20 g 4,4'-Bis-acetoxymethyl-diphenylether werden in 100 ml Methacrylsäure gelöst, mit etwas Hydrochinon und 1 ml konz. Schwefelsäure versetzt und acht Stunden auf ca. 80 °C erhitzt. Danach werden 500 ml Methylenchlorid zugegeben, und die organische Phase wird mit 2 n Natronlauge und mit Wasser gewaschen. Nach dem Einengen verbleiben 15 g (64%) der Verbindung 28.

d) 570 g (1,6 mol) 4,4'-Bis-brommethyl-diphenylether und 346 g (4,8 mol) Acrylsäure werden in 2,5 l Methylisobutylketon in Anwesenheit von 1,4 g Hydrochinon durch Zutropfen von 960 g Triethylamin zur Reaktion gebracht. Nach Aufarbeiten wie unter b) beschrieben verbleiben 360 g (1,065 mol; 67%) 4,4'-Bis(acryloyloxymethyl) diphenylether (Verbindung 29).

e) 142 g (0,4 mol) 4,4'-Bis-brommethyl-diphenylether, 86,4 g (1,2 mol) Acrylsäure und 0,4 g Hydrochinonmonomethylether werden in 700 ml Aceton gelöst und nach Zutropfen von 255 g Triethylamin 5 Stunden zum Rückfluß erhitzt. Es wird vom Ammoniumbromid abgesaugt, eingeengt, in Methylenchlorid aufgenommen, mit 2 n Natronlauge, 2 n Salzsäure und Wasser gewaschen und wiederum eingeengt. Es verbleiben 66,2 g (0,196 mol; 49%) der Verbindung 29.

f) 15 g (60 mmol) 4,4'-Bis-hydroxymethyl-diphenylether und 30 g Triethylamin werden in Methylenchlorid gelöst, und bei 10°C werden 27 g (0,3 mol) Acryloylchlorid, gelöst in etwas Methylenchlorid, zugetropft. Nach 2 Stunden bei Raumtemperatur wird mit Wasser ausgewaschen und das Lösungsmittel im Vakuum abdestilliert. Es verbleiben 15,5 g (46 mmol; 76%) der Verbindung 29.

g) 18,6 g 4,4'-Bis-brommethyl-diphenylsulfid, 13 g Methacrylsäure und 0,3 g Hydrochinon werden in 250 ml Chloroform mit 45 ml Triethylamin 5 Stunden zum Rückfluß gebracht. Es wird abgesaugt, mit 2 n HCl, 2 n NaOH und Wasser gewaschen. Nach dem Einengen verbleiben 12,6 g (66%) der Verbindung 30.

Tabelle II

Beispiele für Verbindungen der Formel I mit m = 0:

| Verbindung Nr. | $R_1$ | $R_2$ |
|---|---|---|
| 28 | 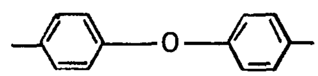 | $CH_3$ |
| 29 | 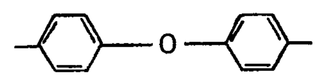 | H |
| 30 | 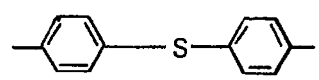 | $CH_3$ |
| 31 | 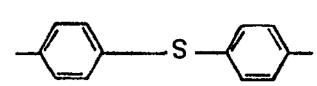 | H |

Beispiel 1

Als Schichtträger für Druckplatten wurde elektrochemisch aufgerauhtes und anodisiertes Aluminium mit einer Oxidschicht von 3 g/m² verwendet, das mit einer wässrigen Lösung von Polyvinylphosphonsäure vorbehandelt worden war.

Es wurde eine Lösung aus:

2 Gt eines Styrol-Maleinsäureanhydrid-Mischpolymerisats mit dem mittleren Molekulargewicht 20 000 und einer Säurezahl von 180–200 (Scripset 540 von Monsanto),

2 Gt Verbindung 13,

0,125 Gt 9-Phenyl-acridin und

0,06 Gt des Azofarbstoffs aus 2,4-Dinitro-6-chlorbenzoldiazoniumsalz und 2-Methoxy-5-acetylamino-N-cyanethyl -N- hydroxyethyl-anilin in

26 Gt Butanon und

14 Gt Butylacetat

auf den oben beschriebenen Träger in der

Weise aufgeschleudert, dass ein Trockengewicht von 3,7–4 $g/m^2$ erhalten wurde. Dann wurde die Platte 2 Minuten bei 100 °C im Umlufttrockenschrank getrocknet.

Die erhaltene Druckplatte wurde mittels einer 5 kW Metallhalogenidlampe im Abstand von 110 cm zwischen Lampe und Vakuumkopierrahmen unter einem 13stufigen Belichtungskeil mit Dichteinkrementen von 0,15 40 Sekunden belichtet.

Anschliessend wurde die Platte manuell mit einem Entwickler folgender Zusammensetzung entwickelt:

3,0 Gt Natriummetasilikat × 9 Wasser,

0,03 Gt nichtionogenes Netzmittel (Kokosfettalkohol-Polyoxyethylenether mit ca. 8 Oxyethyleneinheiten),

0,003 Gt Antischaummittel,

96,967 Gt vollentsalztes Wasser.

Es wurden 5 vollvernetzte Keilstufen erhalten.

Beispiel 2

Zu der in Beispiel 1 angegebenen Beschichtungslösung wurden 0,04 g amorphe, hochporöse Kieselsäure, mittlere Teilchengrösse 8 µm, (Syloid Al 1) hinzugefügt, und die Dispersion wurde auf den Schichtträger so aufgeschleudert, dass ein Schichtgewicht von 3,5 $g/m^2$ erhalten wurde.

Die Platte wurde in gleicher Weise wie in Beispiel 1 weiterverarbeitet.

Es wurden 5 vollvernetzte Keilstufen erhalten.

Die Druckplatte erreichte im konventionellen Feuchtwerk eine Auflage von 180 000 Bogen, im Alkoholfeuchtwerk eine von 90 000 Bogen.

Beispiel 3

Die beschichtete Platte aus Beispiel 2 wurde nach dem Trocknen mit einer 15%igen wässrigen Lösung von Polyvinylalkohol (12%) Restacetylgruppen, K-Wert 4) beschichtet. Nach dem Trocknen wurde eine Deckschicht mit einem Gewicht von 5 $g/m^2$ erhalten.

Teile der Platte wurden dann mittels einer Metallhalogenidlampe 5, 10, 20 bzw. 40 Sekunden unter einem 13stufigen Belichtungskeil mit Dichteinkrementen von 0,15 belichtet und danach mit der in Beispiel 1 beschriebenen Entwicklerlösung entwickelt.

In einem weiteren Versuch wurde die Platte nach dem Belichten 5 Sekunden bei 100 °C im Umlufttrockenschrank erhitzt und anschliessend entwickelt.

Die folgende Tabelle zeigt, dass die Schicht streng reziprok arbeitet und dass der Nacherhitzungsschritt eine deutliche Zunahme der Anzahl der vollvernetzten Keilstufen zur Folge hat.

| | Belichtungszeit (Sekunden) | | | |
|---|---|---|---|---|
| | 5 | 10 | 20 | 40 |
| Keilstufen ohne Nacherhitzung | 3 | 5 | 7 | 9 |
| Keilstufen mit Nacherhitzung | 8 | 9 | 11 | 13 |

Schichten mit anderen Monomeren (z.B. Trimethylolethantriacrylat) vernetzen unter Sauerstoffeinfluss (d.h. ohne Deckschicht) wesentlich weniger als mit Deckschicht (3 Keilstufen ohne Deckschicht, 9 Keilstufen mit Deckschicht bei 40 Sekunden Belichtungszeit).

Beispiel 4

Eine Beschichtungslösung wurde aus

1 Gt eines Methylmethacrylat-Methacrylsäure-Mischpolymerisats mit dem Molekulargewicht 30 000 und der Säurezahl 117,

1 Gt des in Beispiel 1 angegebenen Styrol-Maleinsäureanhydrid-Mischpolymerisats,

2 Gt der Verbindung 29,

0,125 Gt 9-Phenyl-acridin,

0,07 Gt des in Beispiel 1 beschriebenen blauen Farbstoffs und

0,04 Gt der in Beispiel 2 angegebenen Kieselsäure in

21 Gt Butanon und

11 Gt Butylacetat

hergestellt und auf den in Beispiel 1 beschriebenen Aluminiumträger so aufgeschleudert, dass ein Schichtgewicht von 5 $g/m^2$ erhalten wurde.

Belichtung, Entwicklung und Beurteilung erfolgten wie in Beispiel 1.

Es wurden 4 vollvernetzte Keilstufen erhalten.

Beispiel 5

Auf den in Beispiel 1 angegebenen Schichtträger wurden Lösungen folgender Zusammensetzung so aufgeschleudert, dass ein Schichtgewicht von 3,5 $g/m^2$ erhalten wurde:

2 Gt des in Beispiel 1 angegebenen Mischpolymerisats,

1,8 Gt einer der in Tabelle III angegebenen Verbindungen,

0,5 Gt 9-Phenyl-acridin und

0,05 Gt des Azofarbstoffs aus Beispiel 1 in

23 Gt Butanon,

12 Gt Butylacetat und

12 Gt Ethylenglykolmonomethylether.

Die Platten wurden 40 Sekunden belichtet und mit der in Beispiel 1 angegebenen Entwicklerlösung entwickelt.

Es wurde die folgende Anzahl vollvernetzter Keilstufen erhalten:

Tabelle III

| Verb.-Nr. | Keilstufen | Verb.-Nr. | Keilstufen |
|---|---|---|---|
| 1 | 3 | 20 | 3 |
| 2 | 1–2 | 21 | 3 |
| 3 | 2 | 22 | 5 |
| 4 | 2–3 | 23 | 6 |
| 5 | 1–2 | 24 | 5 |
| 6 | 1–2 | 25 | 3 |
| 7 | 1 | 28 | 7 |
| 5 | 2 | 29 | 7 |
| 9 | 2–3 | 30 | 3 |
| 10 | 2 | 31 | 3–4 |
| 11 | 3 | | |
| 12 | 2 | | |

Tabelle III (Fortsetzung)

| Verb.-Nr. | Keilstufen | Verb.-Nr. | Keilstufen |
|---|---|---|---|
| 13 | 2 | | |
| 14 | 1–2 | | |
| 15 | 2 | | |
| 16 | 1–2 | | |
| 17 | 2 | | |
| 18 | 1 | | |

Beispiel 6

6,5 Gt eines Terpolymerisats aus n-Hexylmethacrylat, Methacrylsäure und Styrol (60:30:10 Gt) mit einem mittleren Molekulargewicht von ca. 35.000,

5,6 Gt des in Beispiel 1 beschriebenen Monomeren,

0,2 Gt 9-Phenyl-acridin,

0,03 Gt des blauen Azofarbstoffs aus Beispiel 1 in

25 Gt Butanon,

2 Gt Ethanol und

1 Gt Butylacetat

wurden auf eine biaxial verstreckte und thermofixierte Polyethylenterephthalatfolie der Stärke 25 µm so aufgeschleudert, dass nach dem Trocknen bei 100 °C ein Schichtgewicht von 35 g/m$^2$ erhalten wurde.

Die so hergestellte Trockenresistfolie wurde mit einer handelsüblichen Laminiervorrichtung bei 120 °C auf eine mit 35 µm starker Kupferfolie kaschierte Phenoplast-Schichtstoffplatte laminiert und 20 Sekunden mit einem handelsüblichen Belichtungsgerät belichtet. Als Vorlage diente eine Strichvorlage mit Linienbreiten und Abständen bis herab zu 80 µm.

Nach der Belichtung wurde die Polyesterfolie abgezogen und die Schicht mit der in Beispiel 1 beschriebenen Entwicklerlösung in einem Sprühentwicklungsgerät 90 Sekunden lang entwickelt.

Die Platte wurden dann 30 Sekunden mit Leitungswasser gespült, 30 Sekunden in einer 15%igen Ammoniumperoxydisulfat-Lösung angeätzt und sodann nacheinander in den folgenden Elektrolytbädern galvanisiert:

1) 30 Minuten in einem Kupferelektrolytbad der Firma Schlötter, Geislingen/Steige, Typ «Glanzkupfer-Bad»

Stromdichte: 2,5 a/dm$^2$

Metallaufbau: ca. 14 µm

2) 10 Minuten in einem Nickelbad Typ «Norma» der Firma Schlötter, Geislingen/Steige

Stromdichte: 4 A/dm$^2$

Metallaufbau: 9 µm

Die Platte zeigte keinerlei Unterwanderungen oder Beschädigungen.

Die Platte konnte sodann in 5%iger KOH-Lösung bei 50 °C entschichtet und das freigelegte Kupfer in den üblichen Ätzmedien weggeätzt werden.

Beispiel 7

Die in Beispiel 6 beschriebene Photoresistlösung wurde wie dort beschrieben auf eine mit 35 µm starker Kupferfolie kaschierte Phenoplast-Schichtstoffplatte aufgeschleudert und getrocknet (30 g/m$^2$).

Analog zu Beispiel 6 wurde die Platte belichtet, entwickelt und galvanisiert, wobei anstelle der Vernickelung wie folgt verfahren wurde:

15 Minuten in einem Bleizinnbad LA der Firma Schlötter, Geislingen/Steige

Stromdichte: 1 A/dm$^2$

Metallaufbau: 15 µm

Auch diese Platte zeigte keinerlei Unterwanderungen oder Beschädigungen und liess sich mit KOH-Lösung entschichten und mit üblichen Ätzmitteln ätzen.

Tabelle IV

| Verbindungs-Nr. | Keilstufen |
|---|---|
| 2 | 2 |
| 3 | 4 |
| 4 | 3 |
| 5 | 1 |
| 6 | 1 |
| 7 | 4 |
| 8 | 3 |
| 9 | 5 |
| 15 | 2 |
| 16 | 1 |
| 23 | 5 |
| 28 | 7 |
| 29 | 7–8 |

Beispiel 8

Auf den in Beispiel 1 angegebenen Schichtträger wurde eine Lösung folgender Zusammensetzung so aufgeschleudert, dass ein Schichtgewicht von 3,5 g/m$^2$ erhalten wurde:

2,6 Gt der Verbindung 28,

6,5 Gt eines Styrol-Maleinsäureester-Mischpolymerisats mit einer Säurezahl von 145–160 und einem Erweichungspunkt von 140–160 °C,

70 Gt Ethylenglykolmonomethylether,

0,1 Gt 9-Phenyl-acridin,

0,035 Gt des in Beispiel 1 angegebenen Azofarbstoffs und

1,0 Gt des Umsetzungsprodukts aus 1 mol 2,2,4-Trimethyl-hexamethylendiisocyanat und 2 mol 2-Hydroxy-ethylmethacrylat.

Die beschichtete Platte wurde anschliessend 2 Minuten bei 100 °C im Umlufttrockenschrank getrocknet und mit einer Deckschicht wie in Beispiel 3 versehen. An einem Laserite(R)-Gerät 150 R der Firma Eocom Corp., das mit einem Argon-Ionen-Laser ausgerüstet war, wurde die Platte mit 200 mW und 1200 L/2,54 cm (5,3 mJ/cm$^2$) bestrahlt. Der Bildkontrast nach der Bestrahlung war gut. Anschliessend wurde die Platte mit dem Entwickler von Beispiel 1 entwickelt. Die Zahl der vollvernetzten Keilstufen eines Halbtonstufenkeils betrug bei Belichtung und unmittelbar folgender Entwicklung 3.

Wenn die gleiche Platte in gleicher Weise verarbeitet wurde, jedoch zwischen Belichten und Entwickeln in einem Erhitzungsgerät 7 Sekunden auf 80 °C erhitzt wurde, so wurden 5 Keilstufen erhalten.

Andruck und Auflagendruck wurden in einer Heidelberger Offsetdruckmaschine GTO mit Dahlgren-Feuchtwerk durchgeführt und betrugen 100.000 Bogen. Bei der zwischenerhitzten Platte erhöhte sich die Auflage auf 150.000 Bogen.

**Patentansprüche**

1. Durch Strahlung polymerisierbares Gemisch, das als wesentliche Bestandteile

a) eine polymerisierbare Verbindung mit endständigen Acryl- oder Methacrylsäureestergruppen,

b) ein polymeres Bindemittel, das in wässrigalkalischer Lösung löslich oder mindestens quellbar ist,

c) einen durch Strahlung aktivierbaren Polymerisationsinitiator

enthält, dadurch gekennzeichnet, dass es als polymerisierbare Verbindung (a) eine Verbindung der allgemeinen Formel I

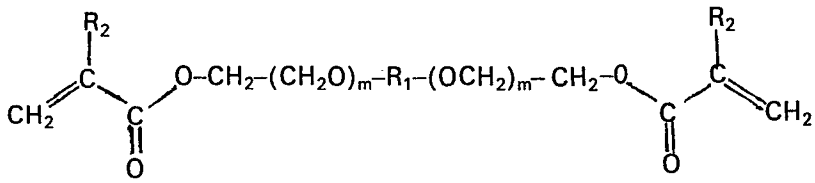

(I)

enthält, worin

$R_1$ eine Naphthylen-, Biphenyldiyl- oder Dinaphthylmethandiylgruppe oder eine aus zwei über eine Brücke verbundenen Phenylenresten gebildete Gruppe ist, wobei die Brücke ein Sauerstoff- oder Schwefelatom eine Sulfongruppe oder eine durch Carbonsäure- oder Carbonsäurealkylestergruppen, Halogenatome oder Phenylgruppen substituierte und gegebenenfalls über einen solchen Substituenten mit der Gruppe $R_1$ eines anderen Moleküls verbundene Alkylengruppe ist,

$R_2$ ein Wasserstoffatom oder eine Methylgruppe und

m 0 oder 1 ist,

wobei m = 1 ist, wenn $R_1$ eine Naphthylen- oder Biphenyldiylgruppe ist.

2. Gemisch nach Anspruch 1, dadurch gekennzeichnet, dass es eine Verbindung der Formel I enthält, worin $R_2$ eine Methylgruppe ist.

3. Gemisch nach Anspruch 1, dadurch gekennzeichnet, dass es eine Verbindung der Formel I enthält, worin $R_1$ eine Diphenylethergruppe ist.

4. Gemisch nach Anspruch 1, dadurch gekennzeichnet, dass es eine Verbindung der Formel I enthält, worin $R_1$ eine Diphenylalkansäureestergruppe ist.

**Revendications**

1. Mélange polymérisable par irradiation qui contient comme constituants essentiels:

a) un composé polymérisable à groupes ester acrylique ou méthacrylique terminaux,

b) un liant polymère qui est soluble ou au moins gonflable dans une solution aqueuse alcaline,

c) un initiateur de polymérisation activable par irradiation, caractérisé en ce qu'il contient comme composé polymérisable (a) un composé de formule générale I:

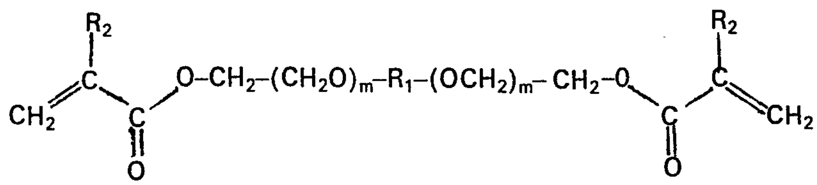

(I)

dans laquelle:

$R_1$ est un groupe naphthylène, biphényldiyle ou dinaphtylméthanediyle ou un groupe formé par deux radicaux phénylène reliés par un pont, le pont étant un atome d'oxygène ou de soufre, un groupe sulfone ou un groupe alkylène substitué par des groupes acide carboxylique ou ester alkylique d'acide carboxylique, des atomes d'halogène ou des groupes phényle et éventuellement reliés par l'intermédiaire d'un de ces substituants au groupe $R_1$ d'une autre molécule,

$R_2$ est un atome d'hydrogène ou un groupe méthyle et

m est égal à 0 ou 1,

m étant égal à 1 lorsque $R_1$ est un groupe naphthyléne ou biphényldiyle.

2. Mélange selon la revendication 1, caractérisé en ce qu'il contient un composé de formule I dans laquelle $R_2$ est un groupe méthyle.

3. Mélange selon la revendication 1, caractérisé en ce qu'il contient un composé de formule I dans laquelle $R_1$ est un groupe diphényléther.

4. Mélange selon la revendication 1, caractérisé en ce qu'il contient un composé de formule I dans laquelle $R_1$ est un groupe ester d'acide diphénylalcanecarboxylique.

**Claims**

1. A mixture which is polymerizable by radiation and contains, as the essential components,

a) a polymerizable compound having terminal acrylic or methacrylic acid ester groups,

b) a polymeric binder, which is soluble or at least swellable in aqueous-alkaline solutions,

c) a polymerization initiator which can be activated by radiation,

characterized in that it contains, as the polymerizable compound (a), a compound of one of the general formula I

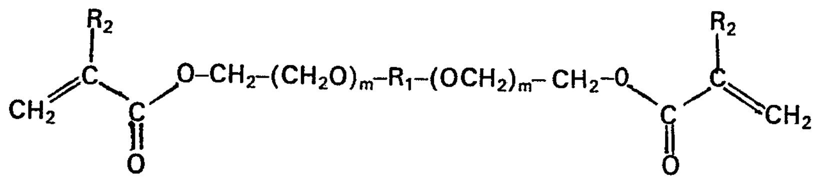

(I)

wherein

$R_1$ is a naphthylene group, a biphenyldiyl group or a dinaphthylmethanediyl group or a group formed by two phenylene groups which are linked by a bridge which may be an oxygen or sulphur atom, a sulfone group or an alkylene group which has been substituted by carboxylic acid groups or carboxylic acid alkyl ester groups, halogen atoms or phenyl groups and which, via such a substituent, may optionally be connected to the group $R_1$ of another molecule;

$R_2$ is a hydrogen atom or a methyl group; and

m is 0 or 1, m being 1 if $R_1$ is a naphthylene groupe or a biphenyldiyl group.

2. A mixture as claimed in Claim 1, containing a compound according to the general formula I, wherein $R_2$ is a methyl radical.

3. A mixture as claimed in Claim 1, containing a compound according to the general formula I, wherein $R_1$ is a diphenyl ether group.

4. A mixture as claimed in Claim 1, containing a compound according to the general formula I, wherein $R_1$ is a diphenyl alkanoic ester group.